# EUROPÄISCHE PATENTANMELDUNG

(11) **EP 4 030 604 A1**
(43) Veröffentlichungstag der Anmeldung: **20.07.2022**
(21) Anmeldenummer: 21152055.6
(22) Anmeldetag: 18.01.2021
(51) Int. Cl.: H02M 1/12, H02M 1/14, H02M 1/44, H02M 7/00

(54) **STROMRICHTER MIT MINDESTENS ZWEI LEISTUNGSHALBLEITERMODULEN**

(71) Anmelder: Siemens Aktiengesellschaft, 80333 München (DE)
(72) Erfinder: Zeyß, Felix, 93059 Regensburg (DE); Kneißl, Philipp, 90427 Nürnberg (DE); Schmenger, Jens, 91301 Forchheim (DE)

(57) **Zusammenfassung**

Die Erfindung betrifft einen Stromrichter (2) mit mindestens zwei, insbesondere gleichartigen, Leistungshalbleitermodulen (4, 6). Um, im Vergleich zum Stand der Technik, eine höhere Zuverlässigkeit zu erreichen, wird vorgeschlagen, dass die Leistungshalbleitermodule (4, 6) jeweils zumindest einen Leistungshalbleiter (10, 12) und Leistungskontakte (18, 20, 22, 24, 46, 48) aufweisen, wobei die Leistungshalbleiter (10, 12) elektrisch leitend mit den Leistungskontakten (18, 20, 22, 24, 46, 48) des jeweiligen Leistungshalbleitermoduls (4, 6) verbunden sind, wobei die Leistungskontakte (18, 20, 22, 24, 46, 48) zur Parallelschaltung der Leistungshalbleitermodule (4, 6) jeweils über eine äußere Beschaltung (32, 34, 54) elektrisch leitend verbunden sind, wobei die Leistungshalbleiter (10, 12) über zumindest ein zusätzliches Verbindungsmittel (36) elektrisch leitend miteinander verbunden sind, wobei das zumindest eine zusätzliche Verbindungsmittel (36) eine geringere parasitäre Induktivität und/oder einen geringeren Serienwiderstand als die äußere Beschaltung (32, 34, 54) aufweist.

## Beschreibung

Die Erfindung betrifft einen Stromrichter mit mindestens zwei, insbesondere gleichartigen, Leistungshalbleitermodulen.

Ferner betrifft die Erfindung ein Verfahren zur Herstellung eines Stromrichters mit mindestens zwei, insbesondere gleichartigen, Leistungshalbleitermodulen.

Die Leistungshalbleitermodule in einem derartigen Stromrichter werden beispielsweise parallelgeschaltet, um einen höheren Laststrom zu erzielen. Unter einem Stromrichter ist beispielsweise ein Gleichrichter, ein Wechselrichter, ein Umrichter oder ein Gleichspannungswandler zu verstehen. Insbesondere bei einer Parallelschaltung von Leistungshalbleitermodulen kann es aufgrund parasitärer Induktivitäten und Widerstände zu einer ungleichmäßigen, insbesondere unsymmetrischen, Stromaufteilung zwischen den Leistungshalbleitermodulen kommen, welche beispielsweise Schwingungen anregen und somit zusätzliche Verlustleistung und/oder Störabstrahlung erzeugen können. Eine Störabstrahlung kann andere Elemente des Stromrichters beeinflussen sowie eine spontane Zerstörung eines Leistungshalbleitermoduls verursachen. Ferner kann es aufgrund einer derartigen unsymmetrischen Stromaufteilung dazu kommen, dass die einzelnen Leistungshalbleitermodule unterschiedlich belastet werden und die Lebensdauer für einzelne Module sinkt.

Vor diesem Hintergrund besteht die Aufgabe der vorliegenden Erfindung darin, einen Stromrichter anzugeben, welcher, im Vergleich zum Stand der Technik, eine höhere Zuverlässigkeit aufweist.

Die Aufgabe wird erfindungsgemäß durch einen Stromrichter mit mindestens zwei, insbesondere gleichartigen, Leistungshalbleitermodulen gelöst, wobei die Leistungshalbleitermodule jeweils zumindest einen Leistungshalbleiter und Leistungskontakte aufweisen, wobei die Leistungshalbleiter elektrisch leitend mit den Leistungskontakten des jeweiligen Leistungshalbleitermoduls verbunden sind, wobei die Leistungskontakte zur Parallelschaltung der Leistungshalbleitermodule jeweils über eine äußere Beschaltung elektrisch leitend verbunden sind, wobei die Leistungshalbleiter über zumindest ein zusätzliches Verbindungsmittel elektrisch leitend miteinander verbunden sind, wobei das zumindest eine zusätzliche Verbindungsmittel eine geringere parasitäre Induktivität und/oder einen geringeren Serienwiderstand als die äußere Beschaltung aufweist.

Darüber hinaus wird die Aufgabe erfindungsgemäß gelöst durch ein Verfahren zur Herstellung eines Stromrichters mit mindestens zwei, insbesondere gleichartigen, Leistungshalbleitermodulen, wobei die Leistungshalbleitermodule jeweils zumindest einen Leistungshalbleiter und Leistungskontakte aufweisen, wobei die Leistungshalbleiter elektrisch leitend mit den Leistungskontakten des jeweiligen Leistungshalbleitermoduls verbunden werden, wobei die Leistungskontakte zur Parallelschaltung der Leistungshalbleitermodule jeweils über eine äußere Beschaltung elektrisch leitend verbunden werden, wobei die Leistungshalbleiter über zumindest ein zusätzliches Verbindungsmittel elektrisch leitend miteinander verbunden werden, wobei das zumindest eine zusätzliche Verbindungsmittel eine geringere parasitäre Induktivität und/oder einen geringeren Serienwiderstand als die äußere Beschaltung aufweist.

Die in Bezug auf den Stromrichter nachstehend angeführten Vorteile und bevorzugten Ausgestaltungen lassen sich sinngemäß auf das Herstellungsverfahren übertragen.

Der Erfindung liegt die Überlegung zugrunde, die Zuverlässigkeit eines Stromrichters durch eine Verbesserung der Symmetrie in der Stromaufteilung zwischen parallel geschalteten Leistungshalbleitermodulen zu erhöhen. Die Leistungshalbleitermodule weisen jeweils zumindest einen Leistungshalbleiter und Leistungskontakte auf, wobei die Leistungshalbleiter elektrisch leitend mit den Leistungskontakten des jeweiligen Leistungshalbleitermoduls verbunden sind. Beispielsweise sind die Leistungshalbleiter jeweils als Transistor, insbesondere als Insulated-Gate-Bipolar-Transistor (IGBT), als Metalloxide-Semiconductor-Field-Effect-Transistor (MOSFET), als Feldeffekttransistor, als Thyristor oder als ein anderer Halbleiter ausgeführt. Beispielsweise ist zumindest einem Transistor eine, insbesondere antiparallele, Diode zugewiesen. Die Leistungskontakte, welche beispielsweise jeweils mit einem Kollektor und/oder Emitter zumindest eines IGBTs verbunden sind, sind zur Parallelschaltung der Leistungshalbleitermodule jeweils über eine äußere Beschaltung elektrisch leitend verbunden. Beispielsweise umfasst die äußere Beschaltung Kupferschienen und/oder Kabel, insbesondere isolierte Kupferkabel zur Parallelschaltung der Leistungshalbleitermodule.

Ferner sind die Leistungshalbleiter über zumindest ein zusätzliches Verbindungsmittel elektrisch leitend miteinander verbunden, wobei das zumindest eine zusätzliche Verbindungsmittel eine geringere parasitäre Induktivität und/oder einen geringeren Serienwiderstand als die äußere Beschaltung aufweist. Durch das zumindest eine zusätzliche Verbindungsmittel werden die parallel geschalteten Module direkt miteinander verbunden, sodass ein Fließen von Ausgleichströme ermöglicht wird. Diese Ausgleichströme verhindern das Aufschwingen der Parallelschaltung und sorgen für eine bessere Symmetrie in der Stromaufteilung. Das zumindest eine zusätzliche Verbindungsmittel umfasst beispielsweise, insbesondere parallel verlaufende, Leiter, welche eine direkte Verbindung zwischen den Leistungshalbleitermodulen herstellen. Die Leiter sind zum Beispiel aus Kupfer oder einer Kupferlegierung hergestellt. Insbesondere durch die direkte Verbindung sind die Leiter des zumindest einen Verbindungsmittels kürzer als die, vergleichsweise langen, Kupferschienen und/oder Kabel der äußeren Beschaltung ausgeführt, sodass das zumindest eine Verbindungsmittel eine geringere Induktivität und/oder einen geringeren Serienwiderstand als die äußere Beschaltung aufweist. Durch die bessere Symmetrie in der Stromaufteilung wird die Zuverlässigkeit des Stromrichters verbessert.

Eine weitere Ausführungsform sieht vor, dass das zumindest eine zusätzliche Verbindungsmittel eine geringere Stromtragfähigkeit als die äußere Beschaltung aufweist. Insbesondere da über das zumindest eine zusätzliche Verbindungsmittel nur kurzzeitig ein Nennstrom fließt, ist dieses mit einer geringeren Stromtragfähigkeit und somit kompakter und kostengünstiger dimensionierbar.

Eine weitere Ausführungsform sieht vor, dass die Leistungshalbleitermodule jeweils ein Gehäuse aufweisen, welches die jeweiligen Leistungskontakte umfasst, wobei zumindest ein Verbindungsmittel durch das Gehäuse verlaufend angeordnet ist. Die Gehäuse sind beispielsweise aus einem Kunststoff hergestellt, wobei zumindest ein Verbindungsmittel, beispielsweise mittels einer abgedichteten Gehäusedurchführung, durch das Gehäuse verläuft und so eine Einhaltung der Luft- und Kriechstrecken gewährleistet ist. Durch die verkürzte Distanz der Gehäusedurchführung wird eine geringere Induktivität des zumindest einen Verbindungsmittels ermöglicht.

Eine weitere Ausführungsform sieht vor, dass zumindest ein Verbindungsmittel in die jeweiligen Gehäuse integrierte Anschlusselemente aufweist, welche über zumindest ein separates Kontaktierungselement elektrisch leitend verbunden sind. Die, z.B. identisch ausgeführten, Anschlusselemente sind beispielsweise mittels einer, insbesondere abgedichteten, Gehäusedurchführung in das Gehäuse integriert. Das separate Kontaktierungselement stellt einfach und kostengünstig eine elektrisch leitende Verbindung zwischen den Anschlusselementen her.

Eine weitere Ausführungsform sieht vor, dass ein Anschlusselement mit einem Kontaktierungselement lösbar verbunden ist. Eine lösbare Verbindung wird beispielsweise mittels einer Nut- und Feder-Verbindung hergestellt. Durch eine derartige lösbare Verbindung wird ein Austausch eines Leistungshalbleitermoduls, beispielsweise bei einem Defekt, erleichtert.

Eine weitere Ausführungsform sieht vor, dass ein Anschlusselement mit einem Kontaktierungselement über eine Steckverbindung verbunden ist. Eine derartige Steckverbindung ist beispielsweise als eine Stecker-Buchse-Verbindung ausgeführt, wobei beispielsweise das Anschlusselement eine Buchse und das Kontaktierungselement einen zugehörigen Stecker aufweist. Eine derartige, insbesondere lösbare, Steckverbindung ist einfach, kostengünstig und zuverlässig.

Eine weitere Ausführungsform sieht vor, dass ein Verbindungsmittel ein erstes Steckelement, welches in ein erstes Gehäuse integriert ist, und ein zweites Steckelement, welches in ein zweites Gehäuse integriert ist und sich vom ersten Steckelement unterscheidet, umfasst, wobei das erste Steckelement und das zweites Steckelement über eine Steckverbindung, insbesondere lösbar, elektrisch leitend verbunden sind. Die Steckelemente sind beispielsweise über eine Stecker-Buchse-Verbindung lösbar miteinander verbunden. Durch eine derartige Verbindungstechnik lassen sich sehr einfach mehrere Leistungshalbleitermodule miteinander verbinden.

Eine weitere Ausführungsform sieht vor, dass ein Verbindungsmittel parallel verlaufende Leiter umfasst. Durch parallel verlaufende Leiter wird eine Kapazität ausgebildet, welche eine parasitäre Induktivität der Leiter zumindest teilweise kompensiert. Die Kapazität zwischen den Leitern ist beispielsweise durch den Abstand und die Überlappung der Leiter flexibel dimensionierbar.

Eine weitere Ausführungsform sieht vor, dass durch die parallel verlaufenden Leiter ein Filter, insbesondere ein RC-Filter, ausgebildet wird, dessen Grenzfrequenz im MHz-Bereich liegt. Insbesondere wird die Kapazität des RC-Filters durch die parallel verlaufenden Leiter und der Widerstand des RC-Filters durch den Serienwiderstand der Leiter ausgebildet. Insbesondere liegt die Grenzfrequenz des ausgebildeten Tiefpassfilters oberhalb einer Betriebsfrequenz des Stromrichters, sodass höhere Frequenzen durch die Filterwirkung des RC-Filters unterdrückt werden, was sich positiv auf das Schwingungsverhalten des Stromrichters auswirkt.

Eine weitere Ausführungsform sieht vor, dass ein Verbindungsmittel zumindest ein Filterelement umfasst. Ein derartiges Filterelement ist beispielsweise ein diskretes Bauelement, insbesondere ein Widerstand, ein Kondensator oder ein RC-Glied. Durch ein derartiges Filterelement wird eine geringere Grenzfrequenz platzsparend ermöglicht, sodass Schwingungen zwischen den Leistungshalbleitermodulen platzsparend gedämpft werden.

Eine weitere Ausführungsform sieht vor, dass das zumindest eine zusätzliche Verbindungsmittel einen Kaltleiter umfasst. Der Kaltleiter enthält beispielsweise Platin und/oder Resistherm (NiFe30) Durch einen derartigen Kaltleiter, dessen Widerstand sich bei steigender Temperatur erhöht, können Ausgleichsströme vornehmlich bei transienten Ereignissen fließen. Ferner wird das zumindest eine zusätzliche Verbindungsmittel gegen Überlastung geschützt.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausgestaltung eines Stromrichters im Querschnitt,
- FIG 2: eine schematische Darstellung einer zweiten Ausgestaltung eines Stromrichters im Querschnitt,
- FIG 3: eine schematische Darstellung einer dritten Ausgestaltung eines Stromrichters im Querschnitt,
- FIG 4: eine schematische Darstellung einer vierten Ausgestaltung eines Stromrichters im Querschnitt,
- FIG 5: eine schematische Darstellung einer fünften Ausgestaltung eines Stromrichters im Querschnitt und
- FIG 6: eine schematische Darstellung einer sechsten Ausgestaltung eines Stromrichters im Querschnitt.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

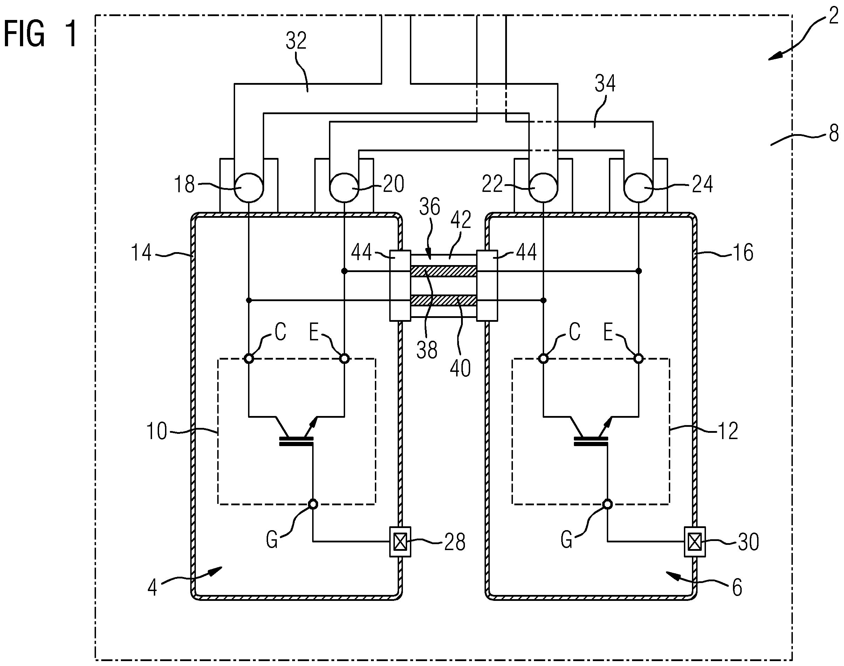

FIG 1 zeigt eine schematische Darstellung einer ersten Ausgestaltung eines Stromrichters 2 im Querschnitt, welcher zwei gleichartige Leistungshalbleitermodule 4, 6 aufweist. Die Leistungshalbleitermodule 4, 6 sind auf einem gemeinsamen Grundkörper 8, welcher beispielsweise als ein aus Aluminium oder einer Aluminiumlegierung gefertigter Kühlkörper ausgeführt ist, angeordnet und weisen jeweils einen Leistungshalbleiter 10, 12 auf, welcher beispielhaft als Insulated-Gate-Bipolar-Transistor (IGBT) ausgeführt ist. Alternativ sind die Leistungshalbleiter 10, 12 als Metalloxide-Semiconductor-Field-Effect-Transistor (MOSFET), als Feldeffekttransistor, als Thyristor, oder als Diode ausgeführt. Insbesondere ist den als IGBT ausgeführten Leistungshalbleitern 10, 12 jeweils eine antiparallele Diode zugewiesen, welche in FIG 1 aus Gründen der Übersichtlichkeit nicht dargestellt ist. Ferner weisen die als IGBT ausgeführten Leistungshalbleiter 10, 12 jeweils einen Kollektor-Kontakt C, einen Emitter-Kontakt E und einen Gate-Kontakt G auf.

Darüber hinaus weisen die Leistungshalbleitermodule 4, 6 jeweils ein Gehäuse 14, 16 auf, welche beispielsweise aus einem Kunststoff hergestellt sind und Leistungskontakte 18, 20, 22, 24 umfassen. Dabei ist ein erster Leistungshalbleiter 10 in einem ersten Gehäuse 14, welches einen ersten Leistungskontakt 18 und einen zweiten Leistungskontakt 20 umfasst, angeordnet, während ein zweiter Leistungshalbleiter 12 in einem zweiten Gehäuse 16, welches einen dritten Leistungskontakt 22 und einen vierten Leistungskontakt 24 umfasst, angeordnet ist. Der Kollektor-Kontakt C des ersten Leistungshalbleiters 10 ist mit dem ersten Leistungskontakt 18 verbunden, während der Emitter-Kontakt E des ersten Leistungshalbleiters 10 dem zweiten Leistungskontakt 20 verbunden ist. Analog ist der Kollektor-Kontakt C des zweiten Leistungshalbleiters 12 mit dem dritten Leistungskontakt 18 verbunden, während der Emitter-Kontakt E des zweiten Leistungshalbleiters 12 mit dem vierten Leistungskontakt 24 verbunden ist. Überdies weisen die Gehäuse 14, 16 der Leistungshalbleitermodule 4, 6 jeweils einen Steuerkontakt 28, 30 auf, wobei der Gate-Kontakt G des ersten Leistungshalbleiters 10 mit einem ersten Steuerkontakt 28 und der Gate-Kontakt G des zweiten Leistungshalbleiters 12 mit einem zweiten Steuerkontakt 30 verbunden ist. Zur Parallelschaltung der Leistungshalbleiter 10, 12 sind die korrespondierenden Leistungskontakte 18, 20, 22, 24 jeweils über eine äußere Beschaltung 32, 34 elektrisch leitend verbunden. Insbesondere sind die Kollektor-Kontakte C der Leistungshalbleiter 10, 12 durch eine erste äußere Beschaltung 32 und die Emitter-Kontakte E der Leistungshalbleiter 10, 12 durch eine zweite äußere Beschaltung 34 elektrisch leitend verbunden. Die äußere Beschaltung 32, 34 umfasst z.B. jeweils zumindest eine Kupferschiene. Zusätzlich oder alternativ kann die äußere Beschaltung 32, 34 Kabel, insbesondere isolierte Kupferkabel, aufweisen.

Darüber hinaus sind die Leistungshalbleiter 10, 12 über ein zusätzliches Verbindungsmittel 36 direkt elektrisch leitend miteinander verbunden. Das zusätzliche Verbindungsmittel 36 umfasst, insbesondere parallel verlaufende, Leiter 38, 40, welche eine direkte Verbindung zwischen den Leistungshalbleitermodulen 4, 6 herstellen, wobei der Emitter-Kontakt E des ersten Leistungshalbleiters 10 über einen ersten Leiter 38 mit dem Emitter-Kontakt E des zweiten Leistungshalbleiters 12 und der Kollektor-Kontakt C des ersten Leistungshalbleiters 12 über einen zweiten Leiter 40 mit dem Kollektor-Kontakt C des zweiten Leistungshalbleiters 12 verbunden sind. Die Leiter 38, 40 sind beispielsweise aus Kupfer oder einer Kupferlegierung hergestellt und als Metallisierung auf einer dielektrischen, insbesondere keramischen, Substrat 42 aufgebracht. Das zusätzliche Verbindungsmittel 36 weist eine geringere parasitäre Induktivität und/oder einen geringeren Serienwiderstand als die äußere Beschaltung 32, 34 auf, da insbesondere die kurzen Leiter 38, 40 des Verbindungsmittels 36 eine geringere Induktivität und/oder einen geringeren Serienwiderstand aufweisen als die, vergleichsweise langen, Kupferschienen und/oder Kabel der äußeren Beschaltung 32, 34. Durch eine derartige direkte Verbindung zwischen den Leistungshalbleitermodulen 4, 6 können Ausgleichströme zwischen den Leistungshalbleitern 10, 12 fließen, welche ein Aufschwingen der Parallelschaltung verhindern und für eine bessere Symmetrie in der Stromaufteilung sorgen. Insbesondere ist das Verbindungsmittel 36 durch die Gehäuse 14, 16 verlaufend angeordnet, wobei Dichtungen 44 das jeweilige Gehäuse 14, 16 im Bereich der Gehäusedurchführung abdichten.

Durch die parallel verlaufenden Leiter 38, 40 ist ein Filter, insbesondere RC-Filter, ausbildbar, dessen Grenzfrequenz oberhalb einer Betriebsfrequenz des Stromrichters 2 liegt.

Beispielsweise liegt die Grenzfrequenz des durch die parallel verlaufenden Leiter 38, 40 gebildeten Filters im MHz-Bereich. Das Verbindungsmittel 36 kann zumindest ein, insbesondere diskretes, Filterelement, z.B. einen Widerstand, einen Kondensator und/oder ein RC-Glied, umfassen. Schwingungen zwischen den Leistungshalbleitermodulen 4, 6 werden durch ein derartiges Filter gedämpft. Zusätzlich oder alternativ kann das Verbindungsmittel einen Kaltleiter, wie Platin oder Resistherm (NiFe30), umfassen. Insbesondere ist zumindest einer der Leiter 38, 40 aus einem Kaltleiter hergestellt. Durch einen derartigen Kaltleiter, dessen Widerstand sich bei steigender Temperatur erhöht, sodass Ausgleichsströme vornehmlich bei transienten Ereignissen fließen können. Ferner wird das Verbindungsmittel 36 gegen Überlastung geschützt.

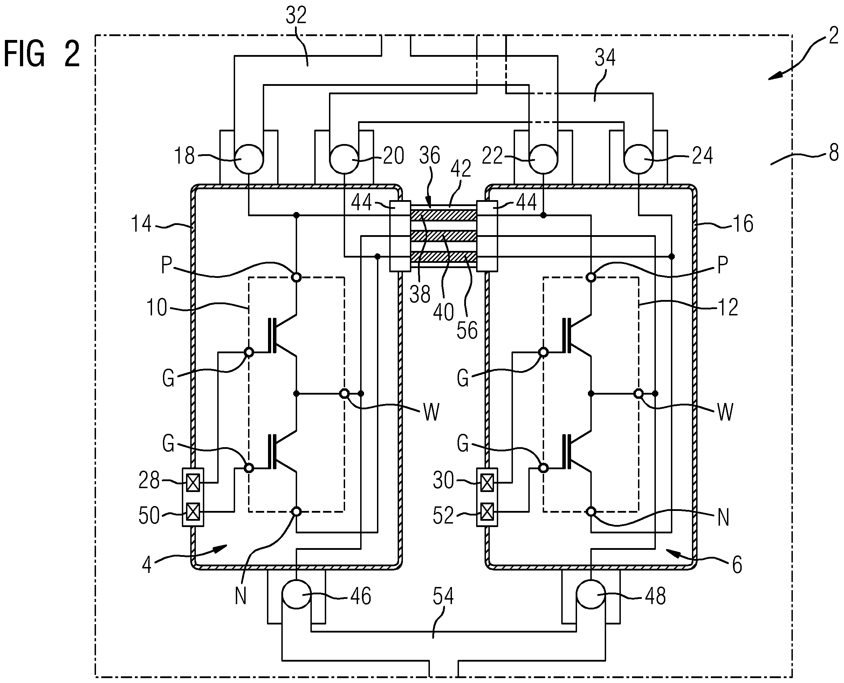

FIG 2 zeigt eine schematische Darstellung einer zweiten Ausgestaltung eines Stromrichters 2 im Querschnitt, wobei die Leistungshalbleiter 10, 12 jeweils als Halbbrücke ausgeführt sind. Eine Halbbrücke, welche aus zwei gestapelte IGBTs aufgebaut ist, umfasst einen positiven Spannungsversorgungskontakt P, einen negativen Spannungsversorgungskontakt N, einen Wechselspannungskontakt W und zwei Gate-Kontakte G. Der positiven Spannungsversorgungskontakt P des ersten Leistungshalbleiters 10 ist mit dem ersten Leistungskontakt 18 verbunden, während der negative Spannungsversorgungskontakt N des ersten Leistungshalbleiters 10 mit dem zweiten Leistungskontakt 20 verbunden ist. Analog ist der positiven Spannungsversorgungskontakt P des zweiten Leistungshalbleiters 12 mit dem dritten Leistungskontakt 22 verbunden, während der negative Spannungsversorgungskontakt N des zweiten Leistungshalbleiters 12 mit dem vierten Leistungskontakt 24 verbunden ist. Ferner sind der Wechselspannungskontakt W des ersten Leistungshalbleiters 10 mit einem fünften Leistungskontakt 46 und der der Wechselspannungskontakt W des zweiten Leistungshalbleiters 12 mit einem sechsten Leistungskontakt 48 verbunden. Die Gate-Kontakte G des ersten Leistungshalbleiters 10 und des zweiten Leistungshalbleiters 12 sind jeweils mit einem Steuerkontakt 28, 30, 50, 52 verbunden.

Zur Parallelschaltung der Leistungshalbleiter 10, 12 sind die korrespondierenden Leistungskontakte 18, 20, 22, 24, 46, 48 jeweils über eine äußere Beschaltung 32, 34, 54 elektrisch leitend verbunden. Insbesondere sind die positiven Spannungsversorgungskontakte P der Leistungshalbleiter 10, 12 durch eine erste äußere Beschaltung 32, die negativen Spannungsversorgungskontakte N der Leistungshalbleiter 10, 12 durch eine zweite äußere Beschaltung 34 und die Wechselspannungskontakte W der der Leistungshalbleiter 10, 12 durch eine dritte äußere Beschaltung 54 elektrisch leitend verbunden. Die äußere Beschaltung 32, 34, 54 umfasst z.B. jeweils zumindest eine Kupferschiene. Zusätzlich oder alternativ kann die äußere Beschaltung 32, 34, 54 Kabel, insbesondere isolierte Kupferkabel, umfassen.

Darüber hinaus sind die Leistungshalbleiter 10, 12 über ein zusätzliches Verbindungsmittel 36 direkt elektrisch leitend miteinander verbunden. Das zusätzliche Verbindungsmittel 36 umfasst, insbesondere parallel verlaufende, Leiter 38, 40, 56 welche eine direkte Verbindung zwischen den Leistungshalbleitermodulen 4, 6 herstellen, wobei der positive Spannungsversorgungskontakt P des ersten Leistungshalbleiters 10 über einen ersten Leiter 38 mit dem positiven Spannungsversorgungskontakt P des zweiten Leistungshalbleiters 12, der negative Spannungsversorgungskontakt N des ersten Leistungshalbleiters 12 über einen zweiten Leiter 40 mit dem negativer Spannungsversorgungskontakt N des zweiten Leistungshalbleiters 12 und der Wechselspannungskontakt W des ersten Leistungshalbleiters 10 über einen dritten Leiter 56 mit dem Wechselspannungskontakt W des zweiten Leistungshalbleiters 12 verbunden sind. Die weitere Ausführung des Stromrichters 2 in FIG 2 entspricht der in FIG 1.

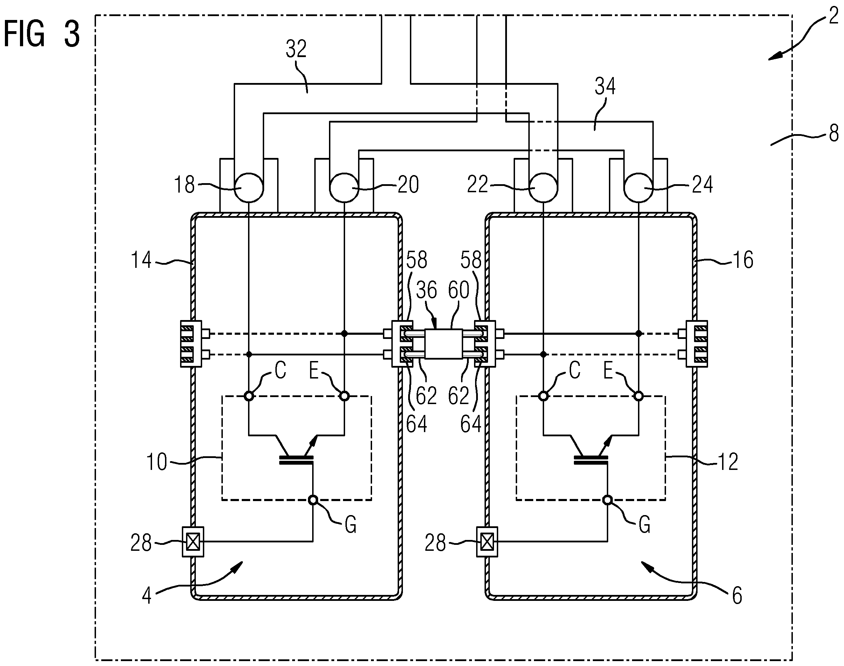

FIG 3 zeigt eine schematische Darstellung einer dritten Ausgestaltung eines Stromrichters 2 im Querschnitt, wobei das Verbindungsmittel 36, insbesondere identische, in die jeweiligen Gehäuse 14, 16 integrierte Anschlusselemente 58 aufweist, welche über ein, insbesondere achsensymmetrisches, separates Kontaktierungselement 60 elektrisch leitend verbunden sind. Das Kontaktierungselement 60 ist beidseitig über eine Steckverbindung lösbar mit den in den Gehäusen 14, 16 integrierten Anschlusselementen 58 verbunden. Die Steckverbindung ist als Stecker-Buchse-Verbindung ausgeführt, wobei das Kontaktierungselement 60 beispielhaft Stecker 62 aufweist, welche in jeweils passende Buchsen 64 der Anschlusselemente 58 gesteckt werden. Die weitere Ausführung des Stromrichters 2 in FIG 3 entspricht der in FIG 1.

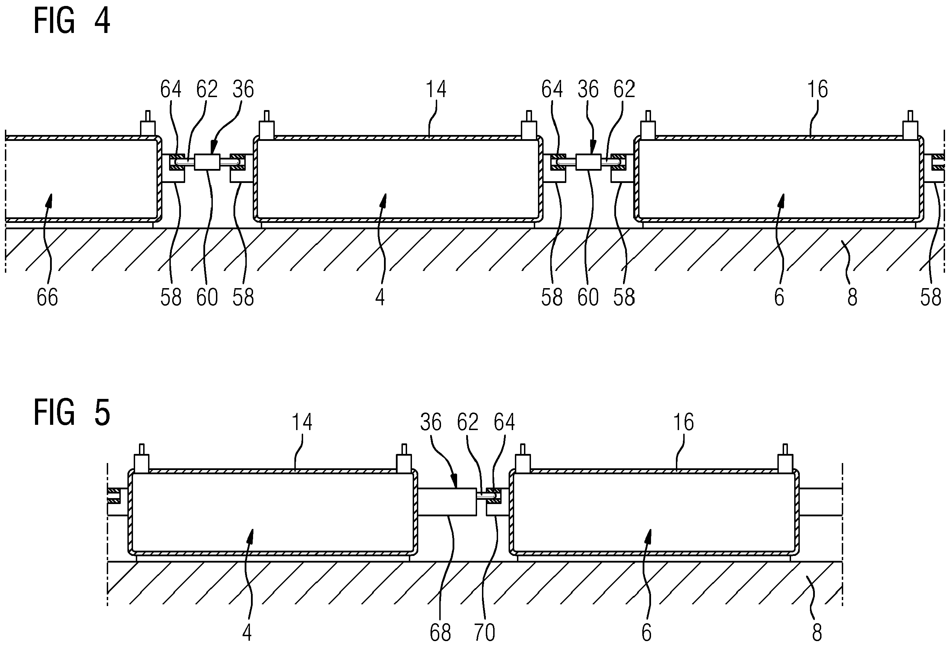

FIG 4 zeigt eine schematische Darstellung einer vierten Ausgestaltung eines Stromrichters 2 im Querschnitt, welcher beispielhaft drei gleichartige Leistungshalbleitermodule 4, 6, 66 aufweist. Die Leistungshalbleitermodule 4, 6, 66 weisen jeweils einen Leistungshalbleiter auf, welcher aus Gründen der Übersichtlichkeit in FIG 4 nicht dargestellt ist, wobei die Leistungshalbleiter, wie in FIG 3 gezeigt, über eine äußere Beschaltung parallelgeschaltet sind. Darüber hinaus sind die Leistungshalbleiter der Leistungshalbleitermodule 4, 6, 66 über zusätzliche Verbindungsmittel 36 direkt elektrisch leitend miteinander verbunden. Die weitere Ausführung des Stromrichters 2 in FIG 4 entspricht der in FIG 3.

FIG 5 zeigt eine schematische Darstellung einer fünften Ausgestaltung eines Stromrichters 2 im Querschnitt. Das Verbindungsmittel 36 weist ein erstes Steckelement 68, welches in das erste Gehäuse 14 integriert ist, und ein zweites Steckelement 70, welches in das zweite Gehäuse 16 integriert ist und sich vom ersten Steckelement 68 unterscheidet, auf. Beispielhaft weist das erste Steckelement 68 einen Stecker 62 und das zweite Steckelement 70 eine zum Stecker 62 passende Buchse 64 auf. Das erste Steckelement 68 und das zweites Steckelement 70 sind über eine Steckverbindung, insbesondere lösbar, verbunden. Die weitere Ausführung des Stromrichters 2 in FIG 5 entspricht der in FIG 3.

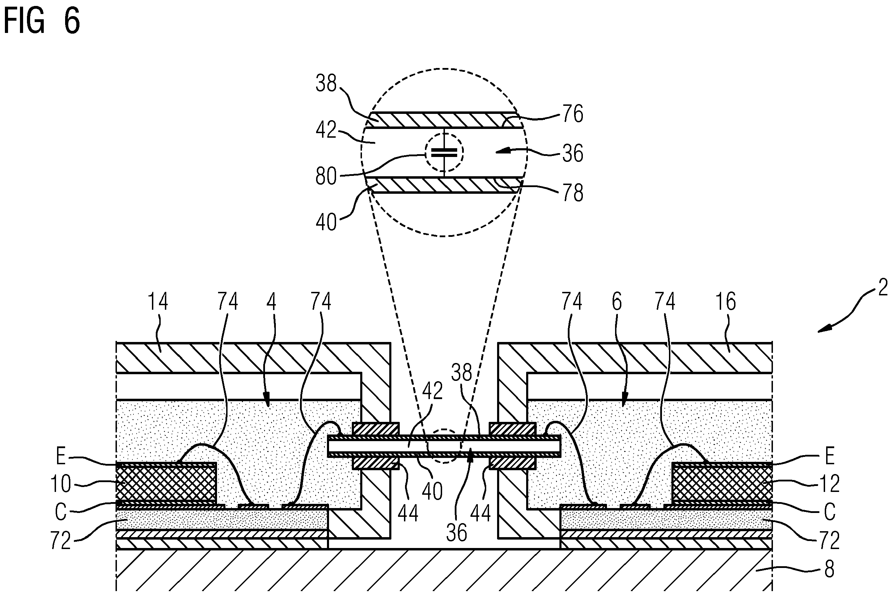

FIG 6 zeigt eine schematische Darstellung einer sechsten Ausgestaltung eines Stromrichters 2 im Querschnitt, welcher zwei Leistungshalbleitermodule 4, 6 mit parallel geschalteten Leistungshalbleitern 10, 12 aufweist. Die als IGBTs ausgeführten Leistungshalbleiter 10, 12 sind über den Kollektor C stoffschlüssig, beispielsweise durch Löten oder Sintern, mit einem DCB-Substrat 72 verbunden, wobei der Emitter E über eine Bondverbindung 74 kontaktiert ist. Das Verbindungsmittel 36, welches die Leistungshalbleiter 10, 12 direkt elektrisch leitend miteinander verbindet, ist ebenfalls über eine Bondverbindung 74 mit dem DCB-Substrat 72 verbunden. Ferner weist das Verbindungsmittel 36 einen ersten Leiter 38 auf, welcher auf einer ersten Seite 76 eines dielektrischen, insbesondere keramischen, Substrats 42 aufgebracht ist. Darüber hinaus weist das Verbindungsmittel 36 einen zweiten Leiter 40 auf, welcher auf einer der ersten Seite 76 gegenüberliegenden zweiten Seite 78 des dielektrischen, insbesondere keramischen, Substrats 42 aufgebracht ist, sodass die Leiter 38, 40 parallel auf gegenüberliegenden Seiten des Substrats 42 angeordnet sind und eine, insbesondere parasitäre, Kapazität 80 durch die parallel verlaufenden Leiter 38, 40 ausgebildet wird. Insbesondere ist die Kapazität 80 Teil eines Filters, insbesondere RC-Filters, dessen Grenzfrequenz oberhalb einer Betriebsfrequenz des Stromrichters 2 liegt. Eine Kontaktierung des zweiten Leiters 40 des Verbindungsmittels 36 erfolgt beispielsweise vom DCB-Substrat 72 über eine Bondverbindung 74 auf die erste Seite 76 des Verbindungsmittels 36, wobei der zweite Leiter 40, insbesondere innerhalb des jeweiligen Gehäuses 14, 16, beispielsweise über eine Durchkontaktierung, auf die zweite Seite 78 des Verbindungsmittels 36 geführt wird. Die weitere Ausführung des Stromrichters 2 in FIG 6 entspricht der in FIG 1.

Zusammenfassend betrifft die Erfindung einen Stromrichter 2 mit mindestens zwei, insbesondere gleichartigen, Leistungshalbleitermodulen 4, 6. Um, im Vergleich zum Stand der Technik, eine höhere Zuverlässigkeit zu erreichen, wird vorgeschlagen, dass die Leistungshalbleitermodule 4, 6 jeweils zumindest einen Leistungshalbleiter 10, 12 und Leistungskontakte 18, 20, 22, 24, 46, 48 aufweisen, wobei die Leistungshalbleiter 10, 12 elektrisch leitend mit den Leistungskontakten 18, 20, 22, 24, 46, 48 des jeweiligen Leistungshalbleitermoduls 4, 6 verbunden sind, wobei die Leistungskontakte 18, 20, 22, 24, 46, 48 zur Parallelschaltung der Leistungshalbleitermodule 4, 6 jeweils über eine äußere Beschaltung 32, 34, 54 elektrisch leitend verbunden sind, wobei die Leistungshalbleiter 10, 12 über zumindest ein zusätzliches Verbindungsmittel 36 elektrisch leitend miteinander verbunden sind, wobei das zumindest eine zusätzliche Verbindungsmittel 36 eine geringere parasitäre Induktivität und/oder einen geringeren Serienwiderstand als die äußere Beschaltung 32, 34, 54 aufweist.

## Patentansprüche

1. Stromrichter (2) mit mindestens zwei, insbesondere gleichartigen, Leistungshalbleitermodulen (4, 6),
wobei die Leistungshalbleitermodule (4, 6) jeweils zumindest einen Leistungshalbleiter (10, 12) und Leistungskontakte (18, 20, 22, 24, 46, 48) aufweisen,
wobei die Leistungshalbleiter (10, 12) elektrisch leitend mit den Leistungskontakten (18, 20, 22, 24, 46, 48) des jeweiligen Leistungshalbleitermoduls (4, 6) verbunden sind,
wobei die Leistungskontakte (18, 20, 22, 24, 46, 48) zur Parallelschaltung der Leistungshalbleitermodule (4, 6) jeweils über eine äußere Beschaltung (32, 34, 54) elektrisch leitend verbunden sind,
wobei die Leistungshalbleiter (10, 12) über zumindest ein zusätzliches Verbindungsmittel (36) elektrisch leitend miteinander verbunden sind,
wobei das zumindest eine zusätzliche Verbindungsmittel (36) eine geringere parasitäre Induktivität und/oder einen geringeren Serienwiderstand als die äußere Beschaltung (32, 34, 54) aufweist.

2. Stromrichter (2) nach Anspruch 1,
wobei das zumindest eine zusätzliche Verbindungsmittel (36) eine geringere Stromtragfähigkeit als die äußere Beschaltung (32, 34, 54) aufweist.

3. Stromrichter (2) nach einem der Ansprüche 1 oder 2,
wobei die Leistungshalbleitermodule (4, 6) jeweils ein Gehäuse (14, 16) aufweisen, welches die jeweiligen Leistungskontakte (18, 20, 22, 24, 46, 48) umfasst,
wobei zumindest ein Verbindungsmittel (36) durch das Gehäuse (14, 16) verlaufend angeordnet ist.

4. Stromrichter (2) nach Anspruch 3,
wobei zumindest ein Verbindungsmittel (36) in die jeweiligen Gehäuse (14, 16) integrierte Anschlusselemente (58) aufweist, welche über zumindest ein separates Kontaktierungselement (60) elektrisch leitend verbunden sind.

5. Stromrichter (2) nach Anspruch 4,
wobei ein Anschlusselement (58) mit einem Kontaktierungselement (60) lösbar verbunden ist.

6. Stromrichter (2) nach einem der Ansprüche 4 oder 5,
wobei ein Anschlusselement (58) mit einem Kontaktierungselement (60) über eine Steckverbindung verbunden ist.

7. Stromrichter (2) nach Anspruch 3,
wobei ein Verbindungsmittel (36) ein erstes Steckelement (68), welches in ein erstes Gehäuse (14) integriert ist, und ein zweites Steckelement (70), welches in ein zweites Gehäuse (16) integriert ist und sich vom ersten Steckelement (68) unterscheidet, umfasst,
wobei das erste Steckelement (68) und das zweites Steckelement (70) über eine Steckverbindung, insbesondere lösbar, elektrisch leitend verbunden sind.

8. Stromrichter (2) nach einem der vorherigen Ansprüche, wobei ein Verbindungsmittel (36) parallel verlaufende Leiter (38, 40) umfasst.

9. Stromrichter (2) nach Anspruch 8,
wobei durch die parallel verlaufenden Leiter (38, 40) ein Filter, insbesondere ein RC-Filter, ausgebildet wird, dessen Grenzfrequenz im MHz-Bereich liegt.

10. Stromrichter (2) nach einem der vorherigen Ansprüche, wobei ein Verbindungsmittel (36) zumindest ein Filterelement umfasst.

11. Stromrichter (2) nach einem der vorherigen Ansprüche, wobei das zumindest eine zusätzliche Verbindungsmittel (36) einen Kaltleiter umfasst.

12. Verfahren zur Herstellung eines Stromrichters (2) mit mindestens zwei, insbesondere gleichartigen, Leistungshalbleitermodulen (4, 6),
wobei die Leistungshalbleitermodule (4, 6) jeweils zumindest einen Leistungshalbleiter (10, 12) und Leistungskontakte (18, 20, 22, 24, 46, 48) aufweisen,
wobei die Leistungshalbleiter (10, 12) elektrisch leitend mit den Leistungskontakten (18, 20, 22, 24, 46, 48) des jeweiligen Leistungshalbleitermoduls (4, 6) verbunden werden,
wobei die Leistungskontakte (18, 20, 22, 24, 46, 48) zur Parallelschaltung der Leistungshalbleitermodule (4, 6) jeweils über eine äußere Beschaltung (32, 34, 54) elektrisch leitend verbunden werden,
wobei die Leistungshalbleiter (10, 12) über zumindest ein zusätzliches Verbindungsmittel (36) elektrisch leitend miteinander verbunden werden,
wobei das zumindest eine zusätzliche Verbindungsmittel (36) eine geringere parasitäre Induktivität und/oder einen geringeren Serienwiderstand als die äußere Beschaltung (32, 34, 54) aufweist.

13. Verfahren nach Anspruch 12,
wobei die Leistungshalbleitermodule (4, 6) jeweils ein Gehäuse (14, 16) aufweisen, welches die jeweiligen Leistungskontakte (18, 20, 22, 24, 46, 48) umfasst,
wobei zumindest ein Verbindungsmittel (36) durch das Gehäuse (14, 16) verlaufend angeordnet wird.

14. Verfahren nach einem der Ansprüche 12 oder 13,
wobei zumindest ein Verbindungsmittel (36) in die jeweiligen Gehäuse (14, 16) integrierte Anschlusselemente (58) aufweist, welche über zumindest ein separates Kontaktierungselement (60), insbesondere lösbar, elektrisch leitend verbunden werden.

15. Verfahren nach Anspruch 13,
wobei ein Verbindungsmittel (36) ein erstes Steckelement (68), welches in ein erstes Gehäuse (14) integriert ist, und ein zweites Steckelement (70), welches in ein zweites Gehäuse (16) integriert ist und sich vom ersten Steckelement (68) unterscheidet, umfasst,
wobei das erste Steckelement (68) und das zweites Steckelement (70) über eine Steckverbindung, insbesondere lösbar, elektrisch leitend verbunden werden.
